Europäisches Patentamt

European Patent Office

Office européen des brevets

(11) Publication number: **0 216 988**
**A1**

(12) **EUROPEAN PATENT APPLICATION**

(21) Application number: **86105829.5**

(22) Date of filing: **01.07.83**

(51) Int. Cl.⁴: **G 01 R 1/16**
**G 01 R 5/06**

(30) Priority: **09.07.82 US 396586**
**09.07.82 US 396587**
**09.07.82 US 396588**

(43) Date of publication of application:
**08.04.87 Bulletin 87/15**

(84) Designated Contracting States:
**DE FR GB IT NL**

(60) Publication number of the earlier application
in accordance with Art. 76 EPC: **0 098 780**

(71) Applicant: **SANGAMO WESTON, INC.**
**180 Technology Drive**
**Norcross Georgia 30092(US)**

(72) Inventor: **Nador, Julius**
**P.O Box 29**
**Blairstown New Jersey 07825(US)**

(74) Representative: **Stoole, Brian David et al,**
**Schlumberger Electronics (U.K.) Limited 124 Victoria**
**Road**
**Farnborough Hampshire GU14 7PW(GB)**

(54) Analog panel meter mechanism.

(57) A moving coil (10) permament magnet (70) electrical meter mechanism comprises pole pieces (6) forming a housing for the permanent magnet (70), and a yoke structure forming with the pole pieces an air gap in which the moving coil moves. The mechanism is provided with a compensating shunt (66,68), made from a material of temperature dependent permeability, for compensating for variations in flux density in the air gap due to temperature changes. The shunt is positioned adjacent and parallel to the magnet, and has its thickness selected to reduce the variations in flux denisty in the air gap to within predetermined limits.

EP 0 216 988 A1

./...

FIG. 2

41.1016/1029/1030D1/5287D

# ANALOG PANEL METER MECHANISM

## Background of the Invention

This invention relates to electrical measurement devices of the moving coil, permanent magnet type.

Moving coil permanent magnet electrical meter mechanisms are known in the prior art, as illustrated by U.S. Pat. Nos. 4 024 472, 3 490 043, 3005 952 and 3 551 812.

Such devices comprise many small, precisely machined or formed parts. Assembly of these prior art devices typically requires several manual insertion or alignment steps which are labor intensive and obviously increases the cost of manufacture.

In the past, it has been the practice to use magnets formed of alloys of cobalt, an expensive material. Meter mechanisms using more readily available and less expensive ceramic magnets have not found widespread use because of high temperature variation in operating characteristics. One illustration of the use of a ceramic magnet in a meter mechanism is described in U.S. Pat. No. 3 490 043. However, this reference fails to disclose any method or apparatus for compensation of the temperature variable characteristics of the magnet.

As described by Parker and Studders, in Permanent Magnets and Their Application, John Wiley and Sons, Inc., 1962, ceramic magnets exhibit a temperature coefficient of approximately -0.2 remanence change per degree centrigrade from room temperature, while various Alnico materials have such coefficients which are typically in the range of -.02 to +.01 percent. Thus, although the base materials for ceramic magnets are inexpensive and plentiful, and are not strategic materials, Alnico magnets (which use up to 36 percent cobalt) are clearly superior in temperature stability.

Two methods are known for compensation of the large temperature coefficient of ceramic magnets. One such method relies on the use of oversaturated pole pieces in conjunction with the ceramic magnet. This is, the magnetic field includes more magnetic flux than can be concentrated by the pole piece. If sufficient margin is provided above the saturation level for the pole piece, a reduction in the magnetic flux density due to temperature increases may leave the air gap flux density unaffected since the pole piece remains at or above its saturation level.

However, this approach prohibits the use of the standard charging and treating calibration procedure for the meter mechanism. In the charging and treating method, the permanent magnet is initially charged to a higher flux density than required to achieve the needed sensitivity. In a subsequent treating step, the magnetization level is reduced, to lower the sensitivity to the desired calibrated value. Where the excessive flux density is relied upon for compensation of the magnet's high temperature coefficient of remanence change, it is apparent that the charging and treating method affects the degree of temperature compensation. Accordingly, the method of "oversaturation" of the pole piece requires the use of an expensive calibration technique for the meter mechanism, in which a separate conductivity shunt is required to be selected, soldered in place and adjusted to bypass a fraction of the meter current. The prior art has thus avoided the use of ceramic permanent magnets for moving coil meter mechanisms, because of both the high temperature variability and the difficulty of sensitivity calibration of temperature compensated mechanisms.

In a second compensation method, a special nickel-iron alloy shunt is used to divert a portion of the flux density from the air gap, the diverted portion decreasing with increasing temperature. This approach is described in Parker et al for a drag device such as a watt-hour meter. No such compensation is available in the prior art, however, for a moving coil permanent magnet type of meter.

## Summary of the Invention

It is a general object of the present invention to provide an improved method and apparatus for measuring electrical quantities.

This and other objects are attained, in accordance with one aspect of the invention by a method for temperature compensation of the permanent magnet of a moving coil meter mechanism having a permanent magnet, pole pieces arranged for forming a housing for said permanent magnet, a yoke structure, and a wound coil movable in an air gap formed between the pole pieces and the yoke structure, said method comprising the steps of (a) determining a magnetic flux density to be established within said air gap for linking said movable wound coil; (b) establishing limits for acceptable variation of said flux density within said air gap for a predetermined temperature range; and (c) reducing variations in said flux density within said air gap to be within the established limits for the predetermined temperature range, including the step of placing an appropriately dimensioned compensating shunt, formed of material having a temperature dependent permeability, adjacent and parallel to said permanent magnet.

Yet another aspect includes a moving coil meter mechanism having a permanent magnet, pole pieces arranged for forming a housing for said permanent magnet, a yoke structure and a wound coil movable in an air gap formed between the pole pieces and the yoke structure, the meter mechanism including means for providing compensation for variations in flux density within said air gap caused by temperature changes, comprising compensating shunt means formed of material having a temperature variable permeability, said compensating shunt means being positioned adjacent and parallel to said permanent magnet and having a thickness selected for reducing the temperature caused variations in flux density within said air gap to predetermined acceptable limits.

## Brief Description of the Drawing

These and other objects and features of the present invention will become more readily apparent to those skilled in the art from the following description when read in conjunction with the accompanying drawing figures, wherein:

Figure 1 shows an exploded assembly view of a meter mechanism according to the present invention;

Figure 2 illustrates the individual components used to form the assemblies of Figure 1, both in exploded and subassemblied form;

Figures 3A and 3B show details of a hub component of the inventive mechanism in plan and side views, respectively; and

Figure 4 shows a bottom view of a top bridge component for the inventive mechanism; and

## Best Mode for Carrying Out the Invention

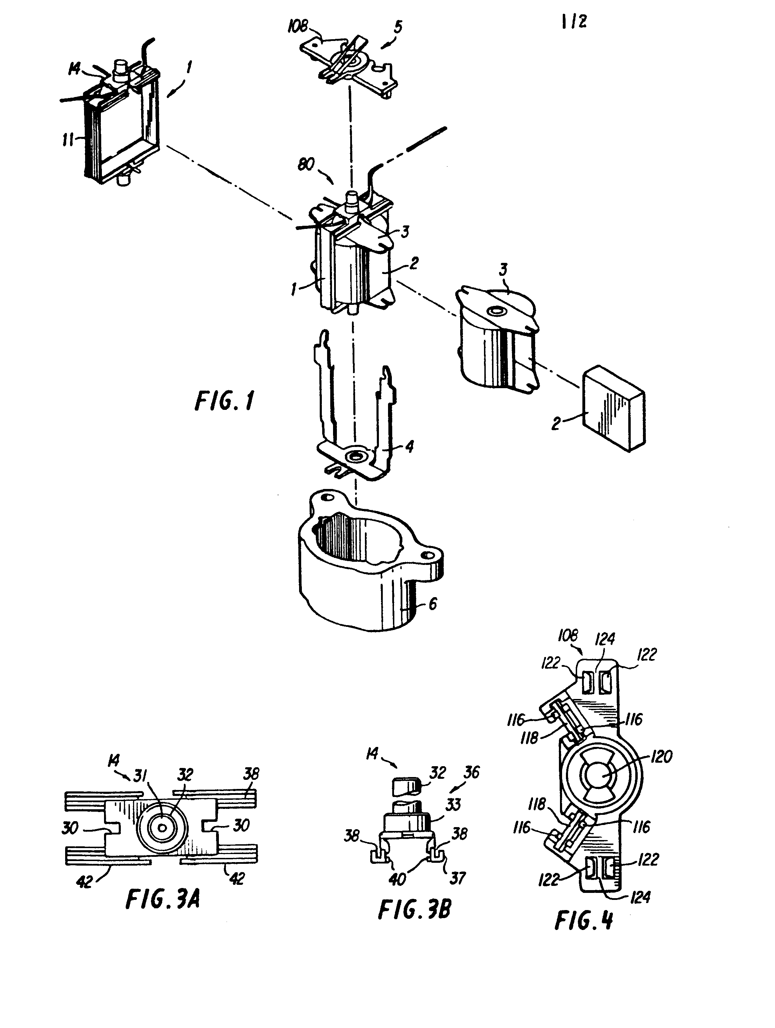

An improved moving coil permanent magnet meter mechanism according to the present invention is shown in Fig. 1 and includes a moving coil and rotor assembly 1, a permanent magnet 2, a housing assembly 3 therefor, a U-shaped bottom bridge support assembly 4, a top bridge assembly 5, and a yoke 6.

As will be appreciated, the several assemblies cooperate to provide angular rotation of moving coil assembly 1 and a deflection of a pointer attached thereto in response to the flow of current through the coil of assembly 1. When assembled, permanent magnet 2 is located within housing 3, and coil and rotor assembly 1 surrounds housing 3. The several assemblies are supported by bottom support assembly 4 and capped by top bridge assembly 5. This supported and capped assembly is mounted within yoke 6, such that the wound coil of assembly 1 is within an annular air gap defined between housing 3 and yoke 6. Magnet 2 generates a magnetic field in the air gap between pole pieces of its housing 3 and yoke 6, and the magnetic field generated by current flow through the winding of coil assembly 1 provides a torque operative to rotate the coil and pointer to a position of equilibrium with the developed torque in the torsional spring (taut band).

Referring to Figure 2, the coil and rotor assembly 1 is shown as including a flangeless moving coil frame 10. For economy and ease of manufacture, coil frame 10 is provided as a simple extruded component, without locating tabs, protrusions, indents, or the like. The coil frame is formed by slicing a rectangular extrusion at appropriate intervals to provide a plurality of inexpensive coil frames of appropriate thicknesses.

A wire winding 12 is provided on coil frame 10. Preferably an adhesively coated wire is wound around the coil frame. Wire 12 may be heated after winding on frame 10 to activate the adhesive, thereby causing the various windings to adhere both to each other and to the frame itself. As a result, an integrated and strengthened rotor subassembly results.

Wire 12 is not wound along the entire width of the surface of coil frame 10 however. Rather, a margin 11 is left along the edges of the frame surfaces to enable clamping engagement of a plastic hub 14 thereto. A balance cross and taut band assembly 16 is provided for mounting a pointer 18 to indicate the electrical quantity being measured. A taut band 20 is attached to balance cross assembly 16, preferably by welding the band to the underside thereof.

A tail section 22 and a side section 24 are provided for static balancing of balance cross assembly 16. Ballast weight may be added to the tail and side sections, as needed, by winding a number of turns of wire thereon. A terminating loop 26 of conductive material is provided on the balance cross for one end of moving coil wire 12, while taut band 20 is used to provide external contact to loop 26, and hence to wire 12. The entire balance cross assembly may be conductive, or only the terminating loop may be conductive.

A pair of upstanding tabs 28 are provided on the central portion of assembly 16 for engaging corresponding notches 30 in the central portion of hub 14. Accordingly, hub 14 is mounted on balance cross assembly 16 by insertion of taut band 20 through an opening 31 in a central tower 32 thereof. Tabs 28 engage notches 30 and are bent over a horizontal base section 33 of hub 14 in order firmly to engage the two components together. See Fig. 3A for example.

Hub 14 is further provided with an assembly aid 36, as shown in detailed Figure 3B. The assembly aid comprises depending skirt portions 37, which include a pair of channels 38 provided therein for engagement by a spreading tool in order to mount the assembled hub and balance cross on coil frame 10. Further, for engaging the margins of coil frame 10, additional rails 40 are provided on the inner surfaces of assembly aid 36. Accordingly, when the combined hub and balance cross assembly is engaged by a spreading tool at channels 38, depending skirt portions 37 are spread so that the assembly may be mounted on coil frame 10. In order to secure the assembly to the coil frame, rails 40 engage the margin edges of the coil frame.

Hub 14 also includes extension sections 42, shown in Figure 3A and in Figure 2, appropriately dimensioned to match the inner dimension of the coil frame, which act to self-center the hub directly on the coil frame and to prevent longitudinal movement thereof.

As will be appreciated by those skilled in the art, the above-described structure enables a simple, quick, and automated assembly of its several components when compared to prior art devices having flanged moving coil frames with tabs thereon for engaging a balance cross or similar component.

While such prior art devices require the balance cross to be manually positioned on the coil frame, for example, and further require manual positioning of the coil frame tabs, the above-described features of the present invention enable automated assembly of its various components.

The rotor assembly including the moving coil is completed by engagement of a lower portion which, similarly to the balance cross of the upper portion, includes a counterbalance arm 44. The counterbalance arm includes a terminal 46 for connection to the other end of moving coil wire 12, and a counterbalance 48 in which a number of notches 50 are provided. The appropriate number of notches is determined in order properly to counterbalance the weight of pointer 18 mounted on balance cross-assembly 16. A number of turns of wire may be wound on terminal 46 to provide appropriate weight balancing. Further, a second taut band portion 52 of the taut band suspension is provided for counterbalance arm 44, and is preferably welded to the upper surface of arm 44. A second hub 54, substantially identical with hub 14, is provided. Taut band portions 20 and 52 provide both a torsion spring for the moving coil assembly and contacts to wire winding 12.

Portion 52 protrudes through a central opening in a central tower of hub 54, and assembly aids and engagement structure similar to that of hub 14 are provided for mounting hub 54 and counterbalance arm 44 on coil frame 10.

A permanent magnet assembly 60, shown at 2 and 3 in Figure 1, includes a pair of pole pieces 62 as seen in Figure 2. The pole pieces are formed of high purity soft iron in order to provide sufficiently high permeability for the intended use. The upper and lower surfaces of the pole pieces are provided with steps, such as illustrated at 64 for the upper surfaces, for accepting a pair of elongated, notched upper and lower support plates 66 and 68 between the pole pieces, thus forming a cage for a magnet 70. The support pieces rest on the lower horizontal surfaces of steps 64, and rigidly separate the vertical surfaces of the steps. The magnet subassembly is formed by welding of the upper support plate 66, and lower support plate 68, to the appropriate positions between the steps 64 of the pole pieces 62. This approach is more cost effective than the prior art approach of cementing or soldering of the magnet 70 to one of the pole pieces.

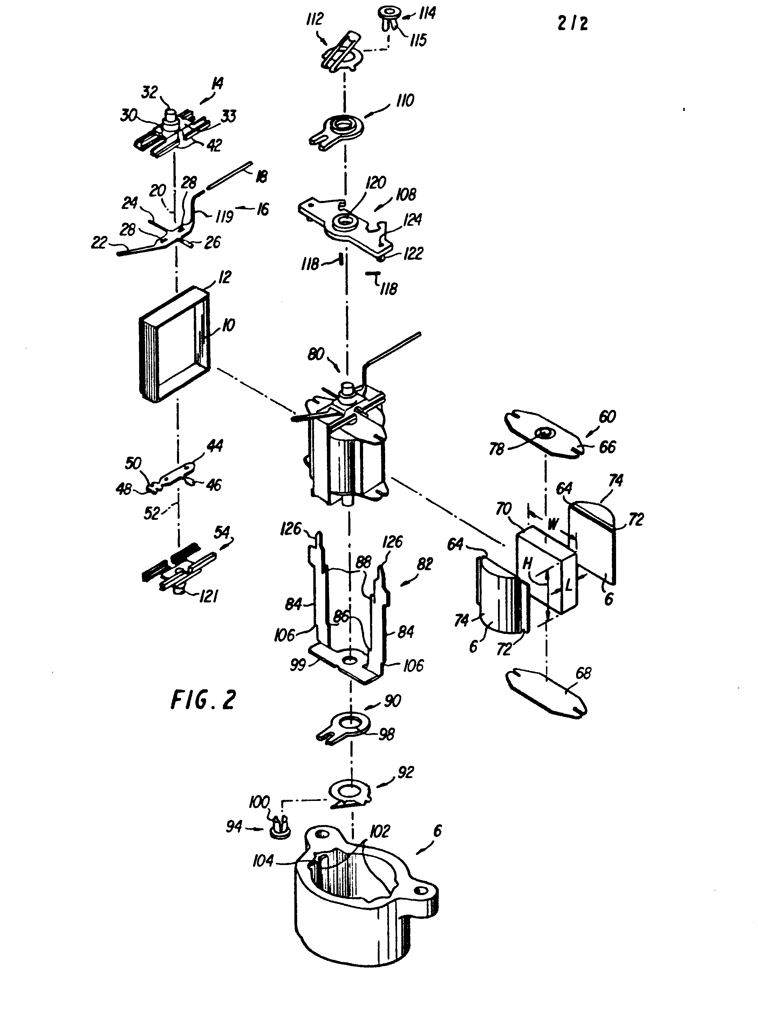

Pole pieces 62 are provided with lips 72, in order to enable the use of larger magnet and so to provide increased meter sensitivity and more efficient operation. Lips 72 act as collectors for additional flux introduced by the magnet. The pole pieces are further provided with arcuate portions 74 for concentrating the magnetic flux within the air gap formed within yoke 6. As described below with reference to Figures 5A-5C, the upper and lower support plates 66 and 68 are each provided with a central area 78, shown as having an annular portion coined into the surfaces thereof. This area is used in combination with an anti-wetting agent to define the shape of a drop of viscous fluid, such as silicon oil, used to provide viscous damping for the moving coil. A similar offset may be provided in the underside of frame 10 for shaping the oil drop. Such viscous damping is particularly helpful in environments wherein the meter movement is subject to vibrations and other similar mechanical stresses.

In accordance with an important feature of the invention, at least one of the support plates 66 and 68 is used as a temperature compensating shunt for permanent magnet 70 which preferably is formed from a magnetic ceramic material, such as barium ferrite. Such compensation is based upon the use of a permeable material, such as nickel-iron alloy, of appropriate dimensions to operate in a saturated state in the air gap. Accordingly, air gap flux variations which would otherwise result due to temperature-induced changes in operating characteristics of the permanent magnet may be compensated for.

Ceramic magnet 70 is shaped to high precision by regrinding (e.g. with a diamond wheel) to have plane parallel surfaces, a process which is more economical than that used to form Alnico magnets, which typically are made by cold forging of a powder in a die.

The dimensions of magnets are chosen to provide the maximum energy product for a normal demagnetization curve. Such curves are published for specific magnet materials, and an operating point is determined by knowledge of the permeance coefficient (B/H) for the specific magnet. As is known in the art, the permeance coefficient is a function of the dimensions of the magnet. For a rectangular ceramic magnet the permeance coefficient is calcuated as follows:

$$B/H = \frac{1.77L}{(W)\,(H)} \sqrt{L\ (W+H)\ (W \cdot H)}$$

where L is the magnet's length in the direction of magnetization, W is the magnet's width, H is the height of the magnet and dimensions are in inches.

From the published demagnetization curves and energy product curves, an ideal B/H coefficient is determined. For example, in one actual sample manufactured in accordance with the present invention, L was set to .230", W was set to .567", and H was set to .640". Thus

$$B/H = \frac{(1.77)(.230)}{(.567)(.640)} \sqrt{(.230)(.567 + .640) + (.567)(.640)}$$

$$= .90$$

Different dimensions may be used in the equation to obtain a permeance closest to the ideal value.

From the actual permeance, the magnet's induction and demagnetizing force (B,H) may be determined. The magnet's temperature coefficient is known (typically -0.19 percent/degree centigrade for barium ferrite magnets). For operation in a desired temperature range, the change in flux density may be determined by multiplying the temperature range (in degrees centigrade) by the temperature coefficient to obtain an expected percentage change in the flux density for the particular temperature range. Multiplication of the normal flux density determined from the demagnetization curve for the particular permeance of the magnet by the determined percentage change in flux density yields the total flux density change, in gauss per square centimeter, for example, in the magnet over the predetermined temperature range.

It is this change in flux density which is to be compensated by the shunt. As described at pages 350-355 in Parker and Studders, the number of flux lines in the shunt at a particular temperature is linearly proportional to the permeability of the material at that temperature and the cross-sectional area of the shunt. Since the permeability of the material changes (decreases) with increasing temperature, it is apparent that the shunt flux decreases with increasing temperature. Inasmuch as the magnet's flux density similarly decreases with temperature, it is seen that for an appropriate cross-sectional area, the shunt diverts an appropriately decreasing portion of the magnets flux from the air gap, thereby providing a substantially constant flux (subject to over- or under-compensation) within the air gap. The cross-sectional area of the shunt is thus determined from the equation $\Phi$ = 46$\mu$A, where $\mu$ is the permeability and A the cross-sectional area of the shunt, and $\Phi$ the shunt flux.

Knowing the flux density to be compensated by the shunt, the number of flux lines required to pass through the shunt are determined by multiplying the flux density change by the magnet area, and the appropriate cross-sectional area of the shunt is thus determined. From a knowledge of the cross-sectional area of the shunt and the width thereof (equal to the magnet width), the thickness of the shunt is thus determined. A number of shunts may be combined to provide a combined thickness equal to the calculated value to provide the desired temperature shunting. Thus one or both of support plates 66 and 68, having the appropriate combined thickness, may be used to provide the temperature compensation for magnet 70.

In one example, an Index 8 ceramic magnet having dimensions $L = 0.230"$, $W = 0.567"$ and $H = 0.640"$ was required to operate over a temperature range of 120°C about a nominal temperature of 25°C. For the magnet dimensions, $B/H = 0.9$, and at 25°C normal $B(\text{Index}) = 1,700$ gauss/cm$^2$ and $H = 1,900$ oersted. With a magnet temperature coefficient of $-0.19$ %/°C, $B = 1,700 \times 20 \times 0.19\% = 64.6$ gauss/cm$^2$. For the magnet dimensions, $\Phi = (65)(2.3413) = 152$ flux lines. The cross-sectional area of the shunt is determined from $A = \Phi / (46)(\mu)$. Finally, a shunt having the appropriate thickness was used to determine the remaining, uncompensated error. Using the previously calculated shunt thickness and the corrected deviation, the total thickness for correcting the total flux line deviation was calculated to be 0.055". Using a pair of shunts having a total thickness of 0.057", one unit displayed $-0.3\%$ maximum error at 5°C and $-0.6\%$ maximum error at 45°C, thus showing a slight degree of over-compensation. A small reduction in compensator thickness would reduce the observed maximum error still further.

Typical compensating alloy materials are 30-32% nickel-iron alloys, sometimes referred to as Curie alloys.

Thus, use of the above-described compensation shunt permits use of inexpensive and readily available ceramic magnets, made of barium ferrite, for example, instead of the more stable but more expensive alloys of cobalt. Such magnets have not found previous use in the moving coil type of meter mechanism because such magnets were previously designed having difficult to machine shapes, because of the unacceptably high temperature variation in their characteristics, and further because previous compensation of temperature variations required the use of expensive sensitivity calibration techniques. By utilizing the type of ceramic magnet described, shunt temperature compensation as well as charge-and-treat calibration techniques may be used, in combination with an inexpensive parallel face diamond wheel grinding technique. The present invention thus overcomes the drawbacks previously associated with the use of these inexpensive magnets.

A bridge assembly is provided for retaining magnet assembly 60 and moving coil assembly 1 within yoke 6. To assemble the complete structure, magnet assembly 60 is inserted into the moving coil assembly, comprised of frame 10, balance cross 16 and counterbalance arm 44 and the upper and lower hubs 14 and 54. The combined moving coil and magnet assembly, shown at 80 in Figures 1 and 2, is inserted into the bottom support assembly 4 of Figure 1. The bottom support assembly includes a bottom bridge structure 82, which comprises a U-shaped element having a pair of upstanding arms 84. Each arm 84 includes a lip 86 providing a rest for bottom support plate 68 of magnet assembly 60. A pair of locking tabs 88 are provided for passage through a pair of side notches in upper support plate 66. Once assembled, tabs 88 are bent inwardly (towards each other), thereby vertically locking the magnet assembly between tabs 88 and 86 of bottom bridge structure 82. The inner edges of arms 84 engage the notches of support plates 66 and 68 to lock magnet assembly 60 against rotary or horizontal movement relative to the bottom bridge.

The bottom support assembly further comprises an abutment 90, a tension spring 92, and a retainer 94. Abutment 90 is used for rearward zeroing of the meter movement. The abutment includes a recessed central portion, shown at 98, having an indented upset for receiving a mating central offset portion at a bottom cross segment 99 of bottom bridge structure 82. These two surfaces provide mating bearing and centering surfaces for operation of zeroing abutment 90. Retainer 94, preferably formed from plastic with a split vertical central portion 100, is inserted through an opening in tension spring 92, through a central opening in recessed portion 98 of abutment 90, and through a central opening 101 in the offset portion at the bottom cross 99 of bridge structure 82. The vertical portion 100 of the plastic retainer snaps into position within central opening 101 of bottom bridge 82, thereby to lock together the bottom support assembly 4.

The assembled combination of moving coil and magnet assembly 80 and bottom support assembly 4 is inserted into yoke 6, which is provided with a pair of grooves 102 for receiving the outer edges of arms 84. Positioning shoulders 104 are provided at the upper end of each of the two grooves 102 for location of the magnetic cage thereagainst. Shoulders 104 provide a rest for the elongated extensions of the upper support plate 66. Having been inserted into yoke 6, and being located thereagainst by the support plate 66 and the positioning shoulders 104, the assembled combination of 4 and 80 is fixed within the yoke by staking a pair of shoulders 106, formed along arms 84 of bottom bridge structure 82, against the bottom surface of yoke 6.

A top bridge 108, shown in detail at Figure 4, is combined with an abutment 110 and a tension spring 112, with the combination fastened together by a second split plastic retaining clamp 114, having a central split vertical portion 115, to form top bridge assembly 5. Abutment 110 provides a frontally located adjustment for the rest position of the meter mechanism. As shown in Figure 4, four pairs of fingers 116 are provided at the bottom of top bridge 108 for retaining a pair of beads 118 which are used as deflection limiting bumpers for the moving coil assembly. The beads are preferably formed of ceramic material, having a low surface tension against other materials, and are dimensioned to provide a snapfit with the fingers 116. Top bridge 108 is the insulated side of the mechanism, and is preferably formed of plastic or other insulating materials.

The combined top bridge assembly 5 is mounted to hub 14 of moving coil and magnet assembly 80. When so mounted, beads 118 form horizontal bumpers for a vertical portion 119 of balance cross assembly 16, thereby providing maximum and minimum deflection limits for the moving coil element of the mechanism.

Tower 32 on hub 14 projects through a central opening 120 within top bridge 108, and into vertical portion 115 of retaining 114, thereby limiting lateral movement of the moving coil and magnet assemblies in the event of vibration to the available radial clearance for tower 32. A shoulder of the horizontal portion 33 of the hub cooperates with the bottom surface of central portion 115 of retainer 114 to limit relative vertical movement between the moving coil and magnet assemblies. A similar arrangement is provided for a bottom tower 121 in bottom hub 54 with respect to central portion 100 of retainer 94.

The offset central portions of abutments 98 and 110 are staked to retain tension springs 92 and 112, respectively. These springs are thus free to rotate on the offset bearing surfaces of the abutments. Tension springs 92 and 112 receive taut band portions 52 and 20, respectively. Rotation of the springs, such as by adjustment of abutments 98 and/or 110, is used to set the moving coil to an appropriate initial position.

Top bridge 108 is provided with pairs of depending parallel plates 122, on either side thereof, formed below openings 124. Bottom bridge structure 82 is provided with a pair of arms 126, which are designed to pass through parallel plates 122 and engage openings 124 of top bridge 108. Upon assembly of the top bridge assembly to the bottom bridge assembly within yoke 6, arms 126 are bent outwardly in order to lock the top and bottom bridge assemblies together and to complete the assembly of the meter mechanism.

As will be appreciated, the above-described structure permits automated assembly of the moving coil assembly, the magnet assembly, the bottom support assembly and the upper bridge assembly. By continuous movement in a single direction, moving coil and magnet assembly 80 may be assembled to bottom support assembly 4. Continuing assembly by movement in the same direction, top bridge assembly 5 is assembled to the bottom support assembly. The assembled components are inserted in yoke 6, again requiring movement only in the same direction previously provided, before or after combining assemblies 80 and 4, or after combining all of the assemblies 80, 4 and 5.

The foregoing description of the preferred embodiment of the invention has been presented for purposes of illustration and description. It is not intended to be exhaustive or to limit the invention to the precise form disclosed, since many obvious modifications and variations are possible in light of the above teaching. The embodiment described was chosen in order best to explain the principles of the invention and its practical application, thereby to enable others skilled in the art best to utilise the invention in various embodiments and with various modifications as are best suited to the particular use contemplated. It is intended that the scope of the invention be defined by the claims appended hereto, when interpreted to obtain the full breadth to which they are fairly and legally entitled.

CLAIMS

1. A method for temperature compensation of the permanent magnet of a moving coil meter mechanism having a permanent magnet, pole pieces arranged for forming a housing for said permanent magnet, a yoke structure, and a wound coil movable in an air gap formed between the pole pieces and the yoke structure, said method being characterized by the steps of:

(a) determining a magnetic flux density to be established within said air gap for linking said movable wound coil;

(b) establishing limits for acceptable variation of said flux density within said air gap for a predetermined temperature range; and

(c) reducing variations in said flux density within said air gap to be within the established limits for the predetermined temperature range, including the step of placing an appropriately dimensioned compensating shunt, formed of material having a temperature dependent permeability, adjacent and parallel to said permanent magnet.

2. The method recited in claim 1, characterized in that said placing step comprises the further steps of:

calculating a thickness for said shunt sufficient to reduce said flux variations to the acceptable limits established therefor; and

placing a compensating shunt having the calculated thickness adjacent and parallel to said permanent magnet.

3. The method recited in claim 2, characterized in that said step of placing said compensating shunt comprises the step of forming a housing for said magnet by interposing said compensating shunt between said pole pieces.

4. The method recited in claim 1, characterized in that said placing step further comprises the steps of:

calculating a thickness for said shunt sufficient to reduce said flux variations to the acceptable limits established therefor; and

placing two shunts having a combined thickness commensurate with said calculated thickness adjacent and parallel to said permanent magnet.

5. The method recited in claim 4, characterized in that said permanent magnet includes surfaces associated with said pole pieces and first and second oppositely disposed planar sides, and said step of placing two shunts comprises the steps of:

placing one of said two shunts adjacent and parallel to one of said oppositely disposed planar sides; and

placing the other of said two shunts adjacent and parallel to the other of said oppositely disposed planar sides.

6. The method recited in any one of claims 1 to 5, characterized by the further step of choosing a ceramic magnet for use as said permanent magnet in said meter mechanism.

7. The method recited in claim 6, characterized by the further step of calibrating said meter mechanism, wherein said step of calibrating comprises the steps of charging and treating said ceramic magnet.

8. A moving coil meter mechanism having a permanent magnet, pole pieces arranged for forming a housing for said permanent magnet, a yoke structure and a wound coil movable in an air gap formed between the pole pieces and the yoke structure, the meter mechanism including means for providing compensation for variations in flux density within said air gap caused by temperature changes, the mechanism being characterized by:

compensating shunt means formed of material having a temperature variable permeability, said compensating shunt means being positioned adjacent and parallel to said permanent magnet and having a thickness selected for reducing the temperature-caused variations in flux density within said air gap to predetermined acceptable limits.

9. The mechanism recited in claim 8, characterized in that said compensating shunt means comprises a plate formed of said material having a temperature variable permeability and further having said selected thickness.

10. The mechanism recited in claim 8 characterized in that said compensating shunt comprises two plates formed of said material having a temperature variable permeability and having a combined thickness commensurate with said selected thickness.

11. The mechanism recited in claim 10, characterized in that said permanent magnet includes surfaces associated with said pole pieces, first and second oppositely disposed planar sides, and wherein one of said two plates is positioned adjacent and parallel to one of said oppositely disposed planar sides, and the other of said two plates is positioned adjacent and parallel to the other of said oppositely disposed planar sides.

12. The mechanism recited in claim 9 or claim 11, characterized in that said compensating shunt is formed as a horizontal support plate between vertically disposed pole pieces forming said housing for said permanent magnet.

13. The mechanism as recited in any one of claims 8 to 12, characterized in that the material having a temperature variable permeability is formed of an alloy of nickel and iron.

14. The mechanism as recited in any one of claims 8 to 13, characterized in that said permanent magnet comprises a ceramic magnet material.

112

FIG.1

FIG.3A

FIG.3B

FIG.4

FIG. 2

0216988

2/2

## EUROPEAN SEARCH REPORT

EP  86 10 5829

### DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | AT-B- 189 278 (LICENTIA) <br> * page 1, lines 1-56; claims 1-5, figures 1-4 * | 1 | G 01 R 1/16 <br> G 01 R 5/06 |
| X | | 1-6 | |
| Y | | 8-14 | |
| Y | DE-B-1 063 412 (VDO) <br> * column 1, line 26 - column 2, line 40 * | 8-14 | |
| A | DE-A-1 935 627 (L. SACHSSE) <br> * claim 5 * | 1 | |
| A | DE-A-3 009 878 (INSTRUMENTI DI MISURA) <br> * claims 1,2; figure * | 1 | TECHNICAL FIELDS SEARCHED (Int Cl 4) <br><br> G 01 R 1/16 <br> G 01 R 1/44 <br> G 01 R 5/06 |

The present search report has been drawn up for all claims

| Place of search | Date of completion of the search | Examiner |
|---|---|---|
| BERLIN | 16-12-1986 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document but published on, or after the filing date
D : document cited in the application
L : document cited for other reasons

& : member of the same patent family, corresponding document

EPO Form 1503 03 82